Europäisches Patentamt

European Patent Office

Office européen des brevets

(11) Veröffentlichungsnummer: **0 328 093**
**A2**

(12) **EUROPÄISCHE PATENTANMELDUNG**

(21) Anmeldenummer: 89102218.8

(22) Anmeldetag: 09.02.89

(51) Int. Cl.⁴: **H03M 7/16 , H03M 13/00**

(30) Priorität: 11.02.88 DE 3804266

(43) Veröffentlichungstag der Anmeldung:
16.08.89 Patentblatt 89/33

(84) Benannte Vertragsstaaten:
AT CH FR GB IT LI SE

(71) Anmelder: **Wild Leitz GmbH**
**Ernst-Leitz-Strasse 30 Postfach 20 20**
**D-6330 Wetzlar 1(DE)**

(72) Erfinder: **Becker, Norbert, Dipl.-Ing.**
**Friedhofstrasse 7**
**D-6300 Giessen-Allendorf(DE)**
Erfinder: **Müller, Hans-Jürgen, Dipl.-Ing.**
**Hasselbornring 56**
**D-6333 Braunfels(DE)**

(54) **Gray-Code-Wandler mit Fehlersignal.**

(57) Verfahren und Schaltungsanordnung zur Umwandlung von Gray-Code-Signalen (12,13) in Zählimpulse (21,22) und zur Bildung eines Zählerstandes, zur Erkennung von Gray-Code-verletzenden Störsignalen und zur Bildung eines Fehlersignals (23) mit einem endlichen Automaten nach Moore oder Mealy, bzw. einem entsprechenden getakteten Schaltwerk (15,46), der kein Fehlersignal (23) bildet, wenn eine Gray-Code-Verletzung von einer zweiten Gray-Code-Verletzung gefolgt wird.
Ausführung als Vierfach-Interpolator (Quadratur-Decoder) für Präzisions-Dimensions-Meßmaschinen mit optoelektronischer Maßstabsabtastung (1). Unterbrechungen des Meßablaufs und Fehler werden reduziert.

Fig. 1

## Gray-Code-Wandler mit Fehlersignal

Die Erfindung betrifft ein Verfahren und eine Schaltungsanordnung zur Umwandlung von Gray-Code-Signalen in Zählimpulse und zur Bildung eines Zählerstandes, zur Erkennung von Gray-Code verletzenden Störsignalen und zur Bildung eines Fehlersignals.

Gray-Code-Signale werden häufig bei Präzisions-Dimensionsmeßmaschinen über die Zwischenstufe von Sinus- und Cosinus-Signalen aus Maßstabsabtastungen gewonnen, zu einer Auswerteeinrichtung übertragen und dort über einen Zähler zu einer Koordinatenangabe als Meßergebnis verarbeitet.

Entsprechend den Präzisionsanforderungen ist es dabei bedeutsam, daß das angezeigte Meßergebnis nicht durch z.B. elektromagnetisch aus der Umgebung eingekoppelte Störsignale verfälscht wird. Störsignale, die mit ihrem zeitlichen Verlauf deutlich von den Meßsignalen abweichen, insbesondere kürzere Impulse bilden, können ausgefiltert werden. Dies wird bei dem Quadraturdecoder HCTL 2000 der Fa. Hewlett Packard (Technical Data April 1986) ausgeführt.

Auch Störsignale mit einem den Meßsignalen ähnlichen Zeitverhalten auf nur einer Eingangsleitung sind in der Regel kein Problem, wenn sie mit ihrer Einschalt- und Ausschaltflanke ein Auf- und ein Ab-Zählereignis vortäuschen, was in der Summe Null ergibt und somit wirkungslos bleibt.

Häufig werden Störsignale aber gleichzeitig in parallele Signalleitungen für die Gray-Code-Signale eingeprägt. Dies verletzt die Definition von Gray-Code-Signalen nach US-C 2 632 058, wonach sich zu gleicher Zeit, praktisch innerhalb eines bestimmten Zeitintervalls, nie zwei (oder mehr) Signalpegel auf den parallelen Signalleitungen ändern dürfen.

Auch Signale, die nur auf einer Eingangsleitung eingeprägt werden, können zu einer Gray-Code-Verletzung führen, wenn sie mit einer ihrer Signalflanken mit einer Flanke eines Meßsignals auf einer anderen Leitung zeitlich zusammentreffen.

Aus Michael M. Butler in Bierman, H., ed., circuits and software for electr. engrs., McGraw-Hill 1983, S. 86, ist eine Schaltungsanordnung zur Umwandlung von Gray-Code-Signalen in Zählimpulse und zur Bildung eines Zählerstands bekannt, die in jedem Fall, in dem gleichzeitig auf beiden Eingängen eine Änderung des Signalpegels erfolgt, eine Fehlermeldung abgibt. Als Eingangssignale sind zwei aus einer Maßstabsabtastung abgeleitete, um 90° phasenverschobene Logik-Rechtecksignale angegeben. Jede einzelne Änderung eines Signalpegels bewirkt einen Auf- oder Ab-Zählimpuls, die Schaltungsanordnung ist damit auch ein Vierfach-Interpolator.

Bei dieser Schaltungsanordnung sind auch die Auf- und Ab-Zählimpulse zeitlich nicht sicher getrennt, wodurch Fehlfunktionen des Zählers entstehen können.

Bei jeder Fehlermeldung eines Gray-Code-Wandlers muß ein Meßvorgang der Meßmaschine abgebrochen und von neuem begonnen werden, was einen großen Zeitaufwand bedeutet.

Wenn ein Gray-Code verletzendes Störsignal von den Pegeländerungen der Meßsignale zeitlich getrennt ist, d. h. wenn auf eine gleichzeitige Pegeländerung auf zwei Eingangssignalleitungen die nächste Pegeländerung wieder gleichzeitig auf diesen beiden Eingangssignalleitungen erfolgt, dann ist diese doppelte Gray-Code-Verletzung als Störung eindeutig von einem Meßsignal unterscheidbar. Die Bildung von Zählimpulsen kann daher unterdrückt werden und ein Fehlersignal braucht nicht gebildet zu werden.

Tritt aber eine Pegeländerung eines Meßsignals während der Dauer eines Störsignals auf zwei Eingangssignalleitungen auf, so wird diese "verschluckt". Die Rückstellung des Pegels wird aber auf einer Eingangsleitung beim Ende des Störsignals, auf der anderen bei der nächsten Pegeländerung des Meßsignals erfolgen. Auf welcher Eingangsleitung aber die Rückstellung des Pegels durch das Störsignal und auf welcher durch das Meßsignal erfolgt, hängt von dem unbekannten zeitlichen Umfang von Störsignal und Meßsignal ab. Dann ist nicht definierbar, ob ein Auf- oder ein Ab-Zählereignis vorliegt und in diesem Fall muß notwendigerweise ein Fehlersignal erzeugt werden.

Gray-Code-Verletzungen sind auch durch Störsignale auf nur einer Signalleitung möglich, wenn zufällig eine Flanke eines Störsignals mit der Flanke eines Meßsignals auf einer anderen Leitung zeitlich zusammentrifft.

Auch hier ist keine Fehlermeldung erforderlich, wenn durch zufälliges Zusammentreffen der zweiten Flanke des Störsignals mit einer zweiten Flanke des Meßsignals eine doppelte Gray-Code-Verletzung entsteht. Das ist nämlich nur möglich, wenn die beiden Flanken des Meßsignals ein Paar von Auf- und Ab-Zählimpulsen mit der Summe Null auslösen müßten, so daß also keine Zählung verfälscht wird.

Der Erfindung liegt die Aufgabe zugrunde, die Zahl der Fehlermeldungen auf das notwendige Maß zu beschränken. Bekannte gattungsgemäße Schaltungsanordnungen sollen einfach substituiert werden.

Diese Aufgabe wird bei einem gattungsgemäßen Verfahren durch die kennzeichnenden Merkmale des Anspruchs 1 gelöst und bei einer gattungsgemäßen Schaltungsanordnung durch die kennzeichnenden Merkmale des Anspruchs 10.

Vorteilhafte Ausgestaltungen der Erfindung ergeben sich durch die Merkmale der abhängigen Ansprüche 2 bis 9 und 11 bis 15.

Die mit der Erfindung erzielten Vorteile liegen insbesondere darin, daß die Unterbrechungen von Meßabläufen durch Fehlermeldungen auf ein Minimum reduziert werden. Zudem kann die Erfindung unmittelbar an die Stelle vorbekannter gattungsgemäßer Schaltungsanordnungen treten, ohne daß an den vor- bzw. nachgeschalteten Funktionselementen Veränderungen erforderlich wären.

Im folgenden wird die Erfindung anhand der in den Zeichnungen dargestellten Ausführungsbeispiele näher beschrieben.

Es zeigen:

Fig. 1 Das Prinzipschaltbild einer Meßschaltung für eine Präzisions-Dimensionsmeßmaschine mit einem erfindungsgemäßen getakteten Schaltwerk nach dem Modell eines Moore-Automaten;

Fig. 2 Beispiel eines Zustandsübergangsgraphen für einen erfindungsgemäßen Moore-Automaten für Vierfach Interpolation;

Fig. 3 Signal-/Zustands-Diagramm;

Fig. 4 Hysterese bei der Erzeugung der Gray-Code-Impulse (zur Synchronisation von Vierfach- und Feininterpolation);

Fig. 5 Prinzipschaltbild für einen Interpolationsautomaten nach dem Modell eines Mealy-Automaten.

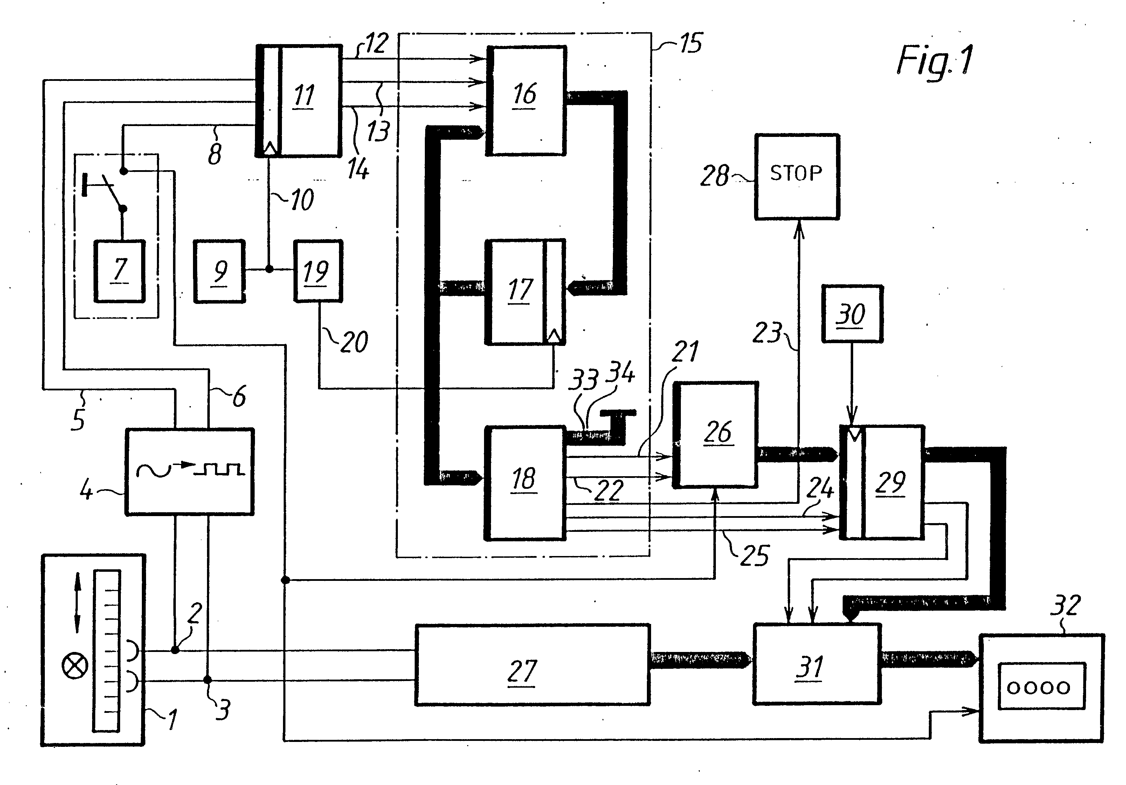

Fig. 1 zeigt zunächst eine bekannte, z.B. optoelektronische, Maßstabsabtasteinrichtung 1, die abhängig von der X-Position eines Objekts ein sinX proportionales Ausgangssignal 2 und ein cosX proportionales Ausgangssignal 3 abgibt.

In einer ebenfalls bekannten Verstärkungs- und Signalformschaltung 4 werden aus den beiden sinX und cosX proportionalen Signalen 2,3 zwei um 90° gegeneinander phasenverschobene Rechteck-Logik-Signale 5,6 erzeugt, die bei jedem Nulldurchgang des sinX- bzw. cosX-Signals 2,3 eine Signalflanke bzw. Pegeländerung aufweisen. Das Paar der Rechteck-Logik-Signale 5,6 stellt Gray-Code-Signale dar, da zu jedem Zeitpunkt höchsten ein Signal 5 oder 6 eine Signalflanke aufweist.

Durch eine Schaltvorrichtung 7 kann ein Rückstell-Signal 8 ausgelöst werden.

Ein Taktgenerator 9 erzeugt ein Taktsignal 10 mit einer bestimmten Taktfrequenz.

Die beiden Rechteck-Logik-Signale 5,6 und das Rückstellsignal 8 sind an die Eingänge eines Registers 11 gelegt, welches durch das Taktsignal 10 gesteuert wird. Die zu einem vom Taktsignal 10 bestimmten Zeitpunkt $t_0$ an den Eingängen des Registers 11 anstehenden Pegel der Signale 5,6 und 8 werden zu den Ausgängen des Registers durchgeschaltet und während des Zeitintervalls bis zu dem nächsten Taktsignal 10 zu einem Zeitpunkt $t_1$ gehalten, zu dem dann die im Zeitpunkt $t_1$ anstehenden Pegel durchgeschaltet werden.

Aus den beiden Eingangssignalen 5 und 6 bildet das Register 11 so die Gray-Code-Ausgangssignale 12 und 13 und aus dem Rückstell-Eingangssignal 8 das Rückstell-Ausgangssignal 14. Die Ausgangssignale 12,13 und 14 sind dabei mit dem Taktsignal 10 synchronisiert und stets für ein festes Zeitintervall fixiert.

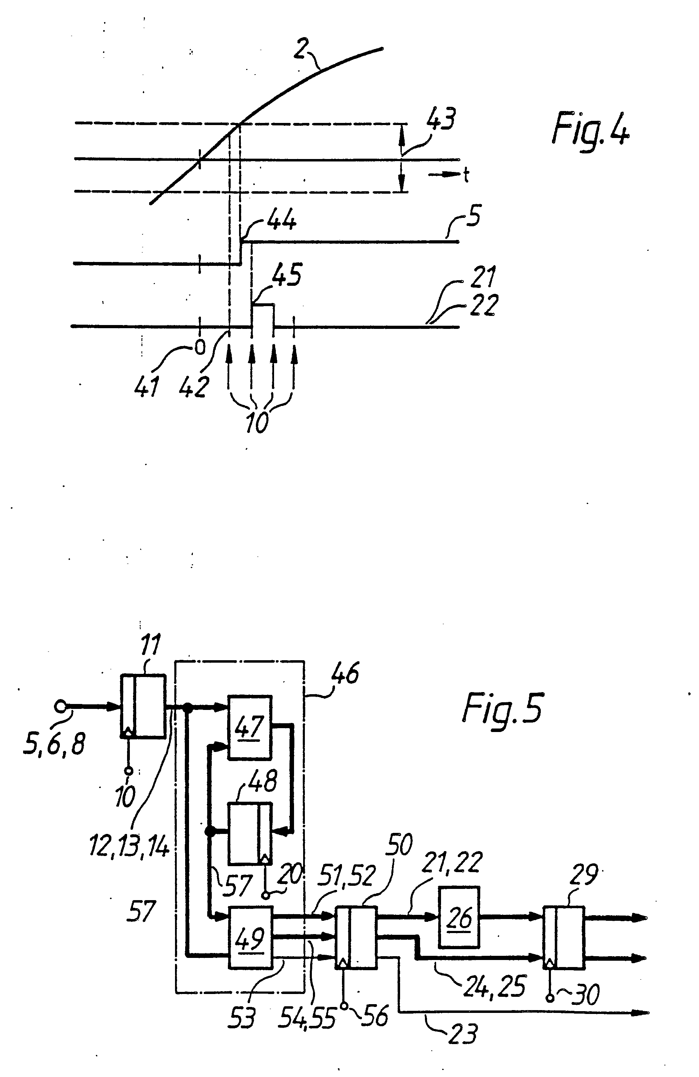

Die synchronisierten Ausgangssignale 12,13 und 14 sind an die Eingänge eines getakteten Schaltwerks 15 angeschlossen, das in diesem Beispiel nach dem Modell eines Moore-Automaten aufgebaut ist und aus einem Überführungs-Schaltnetz 16, einem Register 17 und aus einem Ausgabe-Schaltnetz 18 besteht. Der Moore-Automat ist dadurch bestimmt (Steinbuch, Rupprecht, Hrsg.: Nachrichtentechnik, Bd. III, S. Wendt: Nachrichtenverarbeitung, 3.Aufl., 1982, Springer Verlag, Kap.10.3.1 in S.48-50, Abb.10.50), daß die Eingangssignale 12, 13, 14 nur auf das Überführungs-Schaltnetz 16, nicht aber zugleich auf das Ausgabe-Schaltnetz 18 geführt sind (vgl. Fig. 5).

Die Ausgänge des Überführungs-Schaltnetzes 16 sind über das Register. 17 nicht nur dem Ausgabe-Schaltnetz 18 zugeführt, sondern auch an Eingänge des Überführungs-Schaltnetzes 16 rückgekoppelt. Das Register 17 wird von dem Taktgenerator 9 über ein Verzögerungsglied 19 mit einem Taktsignal 20 gesteuert, das die gleiche Frequenz wie das Taktsignal 10 hat, aber unter Berücksichtigung der Signallaufzeiten in den Elementen 11, 16 und 17 verzögert ist. Es ist möglich und im Beispiel verwirklicht, das Ausgabe-Schaltnetz 18 als triviales Einheits-Schaltnetz, d. h. als direkte Durchverbindung von Eingang zu Ausgang auszuführen.

Das Ausgabe-Schaltnetz 18 enthält also keine Bauelemente und kann somit keine Störungen verursachen. Alle Verknüpfungen müssen also in dem Überführungs-Schaltnetz 16 zusammengefaßt sein.

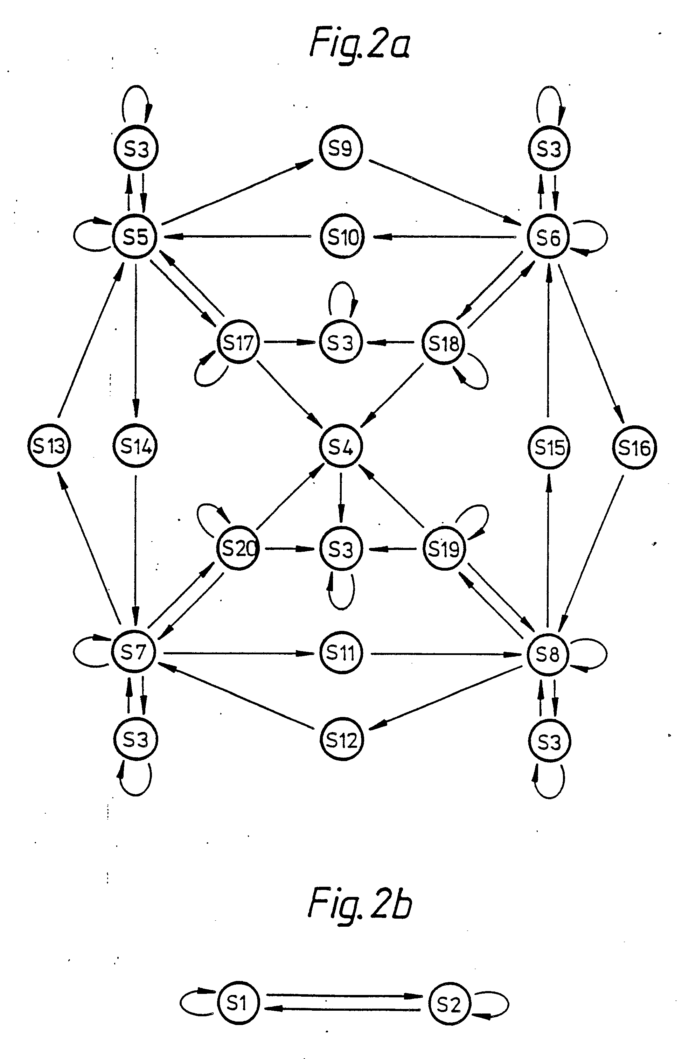

Aufbau und Funktion von Schaltwerken bzw. Automaten sind aus der Nachrichtentechnik (Steinbach, Rupprecht, d. a. 0.) bekannt und werden für die Anwendung bei diesem Beispiel weiter unten auch anhand der Fig. 2 näher erläutert.

Das getaktete Schaltwerk 15 liefert als Ausgangssignal erfindungsgemäß zwei Zählimpulse 21 und 22 und ein Fehlersignal 23. Die Zählimpulse 21, 22 sind im Beispiel als Ab- (21) und Auf- (22) Zähl-Signale realisiert.

Eine vorteilhafte Option sind die im Beispiel eingezeichneten Zählerstatussignale 24 und 25 an zwei weiteren Ausgängen. Diese dienen der Synchronisation eines durch die Zählimpulse 21,22 gesteuerten Zählers 26 mit einem als Option vorgesehenen Feininterpolator 27. Der Feininterpolator 27 und die Synchronisation werden weiter unten auch anhand der Fig. 4 näher beschrieben.

Das Fehlersignal 23 wird einer Fehlermeldeeinrichtung 28 zugeführt. Außer einer Anzeige für einen Bediener kann diese Fehlermeldeeinrichtung 28 auch automatische Funktionen wie den Abbruch eines Meßvorgangs, Neubeginn aus definierter Anfangsstellung, Auslösen des Rückstell-Signals 8 übernehmen.

Die Ausgänge des Zählers 26 und die Zählerstatussignale 24 und 25 werden einem Register 29 zugeführt, das durch einen weiteren Taktgenerator 30 gesteuert wird. Im dargestellten Beispiel werden die Ausgangssignale des Registers 29 und des Feininterpolators 27 einer Synchronisationseinrichtung 31 zugeführt, welche aus den Eingangssignalen den endgültigen Meßwert bildet und über ihre Ausgangssignale einer Ausgabeeinheit 32 zuführt.

Die Ausgabeeinheit 32 kann im einfachsten Fall eine Anzeige für den Bediener sein, umfaßt in der Regel aber auch die Übergabe an automatische Speicher- und Rechenanlagen.

Das Schaltwerk 15, der Zähler 26 und die Ausgabe 32 können durch das Rückstell-Signal 8 in eine Grundstellung gebracht werden.

Die Funktion eines Automaten wird durch den Zustandsübergangsgraphen vollständig bestimmt.

Fig. 2 zeigt den Zustandsübergangsgraphen eines Moore-Automaten als Modell für das getaktete Schaltwerk 15 in Fig. 1, wobei der Automat das Fehlersignal 23 unter den erfindungsgemäßen Bedingungen erzeugt und als Vierfach-Interpolator wirkt, d. h. für jede Pegeländerung der Eingangssignale 12 und 13 und damit viermal pro Periode des sinX-Signals 2 einen Zählimpuls 21 (Ab)oder 22 (Auf) erzeugt.

Der Automat hat 20 Zustände S1 bis S20, die gekennzeichnet sind durch die Kombination der logischen Werte der Signale 21 bis 25 und weiterer interner Signale (z.B. 33,34). Alle Eingangs- (12 bis 14) und Zustandssignale (21 bis 25, 33,34) sind Rechtecksignale, deren einem Pegel die logische "1", deren anderem Pegel die logische "0" zugeordnet ist.

Der Zustandsübergangsgraph ist in zwei Teile (Fig. 2a und 2b) aufgegliedert.
Fig. 2a zeigt den Teilzustandsübergangsgraphen für die 18 Zustände S3 bis S20. Die Zustände des Automaten sind darin durch Kreise dargestellt.

Der Zustand S3 ist sechsmal eingezeichnet. Dies erlaubt eine übersichtliche zweidimensionale Darstellung. Pfeile kennzeichnen Übergänge zwischen den Zuständen.

Steht der Automat in einem Zeitintervall N des Taktsignals 20 im Zustand Si und liegt in diesem Zeitintervall N eine bestimmte Kombination der Eingangssignale 12,13 und 14 an, so erfolgt beim Übergang in das Zeitintervall N + 1 der Übergang vom Zustand Si entlang eines durch diese Kombination von 12,13 und 14 bestimmten Pfeils zu einem Zustand Sj.

Der Zustand S3 ist der Grundzustand. Er wird aus den Zuständen S5 bis S8 und S17 bis S20 erreicht, wenn das Eingangssignal 14, das Rückstellsignal, aktiviert wird.

Der Zustand S4 steuert die Übergänge zwischen den Zuständen S1 und S2 in Fig. 2b und damit die Fehlermeldung am Fehlerausgang 23. S4 kann aus den Zuständen S17 bis S20 erreicht werden und geht immer über in den Grundzustand S3.

S5 bis S8 sind Ruhezustände. Untereinander sind sie durch die Signale 24 und 25 unterschieden.

Die Zustände S9 bis S16 liegen im Zustandsübergangsgraphen zwischen Ruhezustände S5 bis S8; sie werden stets aus einem Ruhezustand S5 bis S8 erreicht und gehen im nächsten Zeitintervall des Zeittaktes 20 wieder in einen Ruhezustand S5 bis S8 über. Durch diese Abfolge wird jeweils ein Zählimpuls 21,22 erzeugt. Je vier der Zustände S9 bis S16 sind Auf- und Ab-Zählimpulsgeneratoren.

Die Zustände S17 bis S20 werden aus den Ruhezuständen S5 bis S8 erreicht, wenn die Eingangssignale 12 und 13 einen Gray-Code-Fehler aufweisen. Ändert sich in einem folgenden Zeitintervall des Zeittaktes 20 nur eines der Eingangssignale 12 oder 13, so gehen die Zustände S17 bis S20 in den Zustand S4 über. Dies bewirkt im folgenden eine Fehlermeldung. Ohne Änderung der Eingangssignale 12 und 13 bleibt der Zustand S17 bis S20 bestehen, bei Änderung beider Eingangssignale 12 und 13 fällt der Automat wieder in den vorhergehenden Ruhezustand S5 bis S8 zurück, wodurch unnötige Fehlermeldungen vermieden werden.

In Fig. 2b ist in gleicher Darstellung der Teilzustandsübergangsgraph für die Zustände S1 und S2 "Fehlerstatus gesetzt" dargestellt. Die Zustände sind durch das Signal 23 gekennzeichnet.

Im Zustand S2 ist das Signal 23 aktiviert und damit die Fehlermeldung ausgegeben. Vom Zustand S1 erfolgt der Übergang zum Zustand S2, wenn im Teilzustandsübergangsgraphen Fig. 2a der Zustand S4 erreicht ist.

Der Zustand S1 wird aus dem Zustand S2 erreicht, wenn das Rückstellsignal 14 aktiviert ist.

In jeder Periode der Eingangsrechtecksignale 5 und 6 (entsprechend sinX(t) (2) und cosX(t) (3)) zeigen die beiden Signale 5 und 6 zusammen vier Signalflanken. Dies ist auch nach der Synchronisation im Register 11 für die Signale 12 und 13 so. Die Signalflankenfolgefrequenz an den Eingängen des getakteten Schaltwerks 15 ist also das Vierfache der Signalfrequenz von 5 oder 6. Ein Zählereignis (z.B. S8 - S12 - S7) erfordert zwei Übergänge, also zwei Zeitintervalle des Zeittaktes 20. Daher muß die Taktfrequenz des Zeittakts 20 - und damit auch des Zeittakts 10 - mindestens das Achtfache der größten Signalfrequenz betragen.

Durch das Register 11 ist die kürzeste Impulsdauer eines Störsignals auf den Signaleingängen 12 oder 13 des Schaltwerks 15 gerade gleich einem Zeitintervall des Zeittakts 10 bzw. 20.

Folgen die Signalflanken der Meßsignale einander im Abstand nur zweier Zeitintervalle des Zeittakts 10 bzw. 20, so ergeben sich durch Störsignale zahlreiche einfache Gray-Code-Verletzungen auf den Signaleingängen 12 und 13, die aber in den ungetakteten Eingangssignalen 5 und 6 noch gar nicht vorhanden sind.

Es ist daher vorteilhaft, die Taktfrequenz des Zeittakts 10 bzw. 20 mindestens zwanzigmal so groß wie die Signalfrequenz zu wählen, so daß zwischen je zwei Flanken der Meßsignale auf den Signalleitungen 12 und 13 mindestens fünf Zeitintervalle des Zeittakts 10 bzw. 20 liegen. In jeweils vier Zeitintervallen kann ein einzelner Störimpuls auf einer Leitung 12 oder 13 zu einem Auf- und Ab-Zählimpulspaar 22 und 21 mit der Summe Null führen und auch eine doppelte Gray-Code-Verletzung kann erkannt werden. Ein Großteil der Störungen kann so also unschädlich verarbeitet werden. Die maximal zulässige Taktfrequenz des Zeittaktes 10 bzw. 20 wird durch die maximalen Signallaufzeiten in den Schaltelementen 11, 16 bis 18 bzw. 47 bis 50 und 26 bestimmt.

Durch die Gestaltung des Zustandsübergangsgraphen (Fig. 2), die mindestens zwei Übergänge und damit Zeitintervalle des Zeittakts 20 pro Zählimpuls 21 oder 22 erfordert, ergibt sich auch der Vorteil, daß die Zählimpulse 21 oder 22 mit ihrer Dauer von einem Zeitintervall des Zeittakts 20 nie ohne Pause aufeinanderfolgen können, so daß Fehlfunktionen des Zählers 26 vermieden werden.

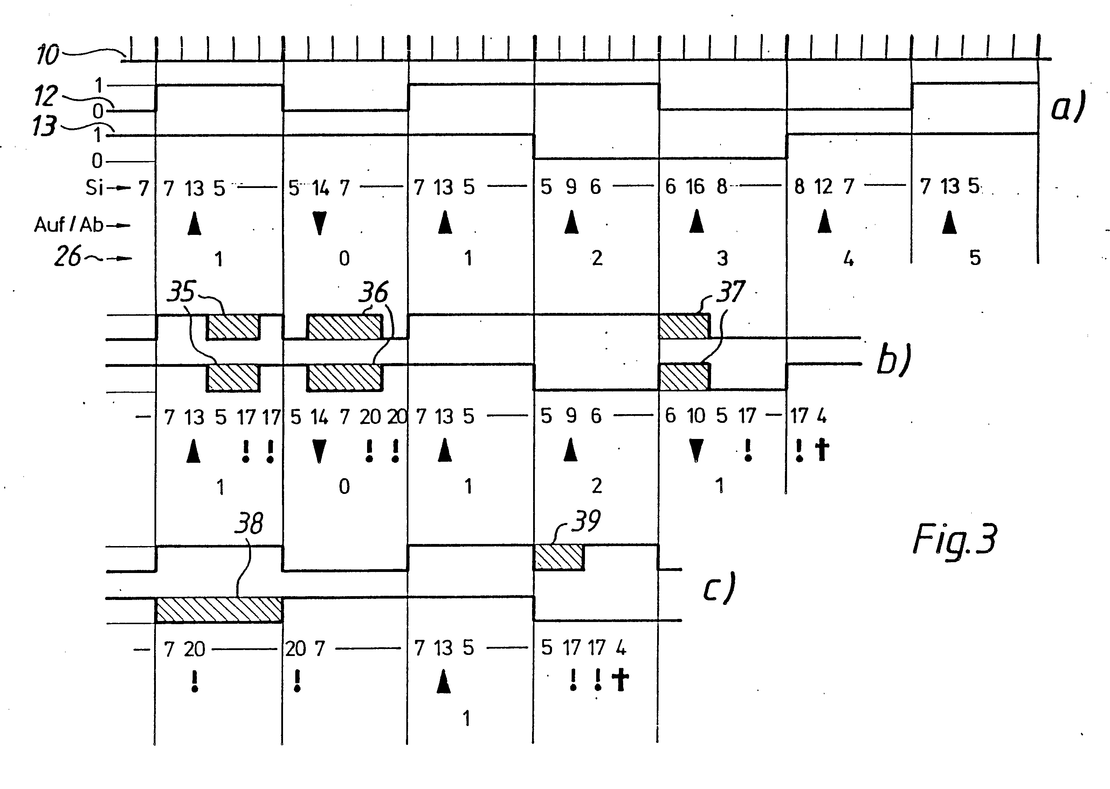

Fig. 3 zeigt ein Signal-Zustandsdiagramm, das beispielhaft die zeitliche Folge der Eingangssignale 12 und 13 und der dadurch gesteuerten Zustände S4 bis S20 für den Moore-Automaten nach dem Zustandsübergangsgraphen Fig. 2 zeigt.
Die Zustände S1 und S2 (Fig. 2b) werden von den Eingangssignalen 12 und 13 nicht unmittelbar beeinflußt, wie auch der Grundzustand S3, der aus S4 oder durch das Rückstellsignal 14 erreicht wird.

Fig. 3a zeigt ein Beispiel einer ungestörten Signalfolge. Die Taktfrequenz ist das Zwanzigfache der maximalen Signalfrequenz und diese wird voll ausgenutzt, d. h. nach je fünf Zeitintervallen des Zeittakts ändert sich jeweils ein Eingangssignal 12 oder 13.

Ubereinander sind dargestellt der Zeittakt 10, die Eingangssignale 12 und 13, die Zustände Si aus S4 bis S20, deren Bedeutung und der Zählerstand des Zählers 26.

Die Zustände Si werden im realen Schaltwerk 15 im Rhythmus des Zeittakts 20 angenommen, der gegen den Zeittakt 10 des Registers 11 und der Eingangssignale 12 und 13 phasenverschoben ist. Die Bedeutung der Zustände Si geben Pfeile für das Erzeugen der Auf-(22) und Ab-(21) Zählimpulse an. Ein Ausrufezeichen kennzeichnet die Zustände S17 bis S20, die erreicht werden, wenn die Eingangssignale 12 und 13 einen Gray-Code-Fehler aufweisen. Ein Kreuz markiert die Fehlermeldung im Zustand S4.

In Fig. 3b sind Beispiele für Störimpulse dargestellt, die gleichzeitig auf beiden Eingangssignalen 12 und 13 auftreten. Unabhängig von der Polarität der Störimpulse wird in den Beispielen 35 und 36 die Zählung nicht beeinträchtigt, die erste Gray-Code-Verletzung führt zu den Zuständen S17 bzw. S20 und die folgende zweite GrayCode-Verletzung führt wieder in einen Ruhezustand S5 bzw. S7 zurück.

Anders ist dies im Beispiel 37, wo der Störimpuls im Eingangssignal 12 eine Meßsignaländerung "verschluckt". Dadurch wird auch die Vorderflanke des Störimpulses auf dem Eingangssignal 12 nicht erkennbar. Die Vorderflanke des Störimpulses auf dem Eingangssignal 13 bewirkt deshalb eine falsche Abwärts-Zählung. Erst die Rückflanke des Störimpulses tritt an beiden Eingangssignalen 12 und 13 auf, diese Gray-Code-Verletzung bewirkt den Übergang in den Zustand S17. Die nächstfolgende Meßsignaländerung ergibt aber keine Gray-Code-Verletzung und so erfolgt der Übergang in den Zustand S4 "Gray-Code-Fehler melden" und in Folge zu S2 "Fehlerstatus gesetzt", wo das Fehlersignal 23 aktiviert ist, und zum Grundzustand S3.

Fig. 3c zeigt ein Beispiel dafür, daß auch Störimpulse auf nur einem Eingangssignal 12 oder 13 zu Gray-Code-Verletzungen führen können. Im Beispiel 38 fallen Vorder- und Rückflanken des Störimpulses auf dem Eingangssignal 13 mit zwei Meßsignalflanken auf dem Eingangssignal 12 zusammen. Es liegt also eine doppelte Gray-Code-Verletzung vor und der Automat geht vom Ruhezustand S7 über den Zustand S20 wieder zu dem Ruhezustand, ohne einen Zählimpuls auszulösen. Auch ohne Störimpuls wäre durch die beiden Flanken des Meßsignals auf dem Eingangssignal 12 in der Summe keine Zählung erfolgt, da ein Auf- und ein Ab-Zählereignis sich gegenseitig aufheben.

Im Beispiel 39 hat ein Störimpuls seine Vorderflanke gleichzeitig mit der Flanke eines Meßsignals auf dem anderen Eingangssignal 13. Dieser Gray-Code-Fehler bewirkt den Übergang in den Zustand S17. Mit der Rückflanke des Störimpulses ändert sich nur ein Eingangssignal 12 und deshalb erfolgt der Übergang vom Zustand S17 in den Zustand S4 "Gray-Code-Fehler melden".

Die Zustände des Automaten werden u. a. durch die Signale 24 und 25 bestimmt. Oben wurde schon dargestellt, daß diese Signale 24 und 25 auch als Option an den Ausgang des getakteten Schaltwerks 15 geführt werden können, um einen Feininterpolator 27 mit dem Vierfach-Interpolator zu synchronisieren. Im Zustandsübergangsgraphen Fig. 2a ist zu sehen, daß ein Zählvorgang des als Vierfach-Interpolator angelegten getakteten Schaltwerks 15 immer von einem Folgezustand (z.B. S7) zu einem Zählimpuls-Generator-Zustand (z.B. S13) und weiter zu einem nächsten Folgezustand (z.B. S5) führt, wobei das geänderte Auf- oder Ab-Zählsignal 21 oder 22 wieder zurück gesetzt wird. Synchron dazu ändert eines der Signale 24 oder 25 seinen Pegel. Die Signale 24 und 25 bilden so einen 2-Bit-Gray-Code-Zähler, der intern zur Unterscheidung der Folgezustände S5 bis S8 dient. Ihr logischer Wert gibt an, in welchem Quadranten der sinX- und cosX-Eingangsfunktionen 2 und 3 der Vierfach-Interpolator jeweils steht. Ihre Verwendung zur Synchronisation einer Feininterpolationseinrichtung wird im folgenden beschrieben.

Wird zwischen zwei Werten des Zählers 26 des Vierfach-Interpolators 11 bis 29 eine Feininterpolation 27 aus der Betragsabtastung der sinX- und cosX-Signale 2 und 3 der Maßstabsabtasteinrichtung 1 durchgeführt, so müssen die Ergebnisse aus beiden Verfahren korrekt zusammengesetzt werden.

In Fig. 4 ist dargestellt, wie beispielsweise bei einer unmittelbar nach einem Nulldurchgang 41 des sinX(t)-Signals 2 erfolgenden Abtastung 42 (Taktsignal 10) wegen der notwendigen Hysterese 43 eines Sinuskomparators der Verstärkungs- und Impulsformschaltung 4 die Pegeländerung 44 des Rechteck-Logik-Signals 5 noch nicht erzeugt ist. Bis zur Erzeugung eines Zählimpulses 45 auf einer der Auf-/Ab-Zählimpulsleitungen 21,22 und des Zählerstandes im Zähler 26 ergeben sich weitere Verzögerungen in den Elementen 11,15 und 26 (Fig. 1).

Die Feininterpolationseinrichtung 27 arbeitet aber schon im auf den Nulldurchgang 41 folgenden Quadranten der sinX(t)-Funktion (Signal 2). Beim Zusammensetzen muß daher der Zählerstand des Zählers 26 um ± 1 korrigiert werden.

Nach dem bekannten Stand der Technik wird die Information zur Korrektur des Zählerstandes aus den zwei niederwertigsten Bits des Zählerstandes des Zählers (entspr. 26) entnommen. Die Zuordnung dieser Bits zu den Quadranten der sinX(t)-Funktion 2 muß dabei erst durch ein Synchronisationsverfahren gewonnen werden, indem die Meßmaschine nach dem Einschalten sehr langsam fährt, bis ein erster Zählimpuls (21 oder 22) und Zählerstand erzeugt und dieser Zählerstand dem in der Feininterpolationseinrichtung 27 erkannten Quadranten zugeordnet wird, oder bis der Bereich der Hysterese 43 sicher verlassen ist und der Zähler 26 entsprechend dem in der Feininterpolationseinrichtung erkannten Quadranten geladen wird.

Dabei entstehen bei großer Differenz zwischen Haft- und Gleitreibung Probleme, z. B. Slip-Stick-Effekte, was auch dazu führt, daß das Synchronisieren oft störend lange dauert.

Durch die Benutzung der in dem erfindungsgemäßen getakteten Schaltwerk 15 erzeugten Signale 24 und 25 wird die Synchronisation in der Synchronisationseinrichtung 31 unmittelbar erreicht und die Probleme des bekannten Verfahrens entfallen.

In Fig. 5 ist als weiteres Beispiel eine erfindungsgemäße Schaltungsanordnung nach dem Modell eines Mealy-Automaten dargestellt.

Wie bei der Schaltung nach Fig. 1 werden Gray-Code-Rechteck-Signale 5, 6 und 8 in dem Register 11 mit dem Taktsignal 10 synchronisiert und dann als Signale 12,13 und 14 bereitgestellt. Diese werden nun von dem getakteten Schaltwerk 46 verarbeitet, das aus einem Überführungs-Schaltnetz 47, einem Register 48 und einem Ausgabe-Schaltnetz 49 besteht. An ein Register 50 sind die Ausgänge 51 bis 55 des getakteten Schaltwerks 46 gelegt. Durch ein Zeittaktsignal 56 mit der Frequenz der Zeittaktsignale 10 und 20 wird das Register 50 gesteuert.

An den Ausgängen des Registers 50 stehen die gleichen Signale 21 bis 25 zur Verfügung, wie an den Ausgängen des getakteten Schaltwerks 15 nach dem Modell des Moore-Automaten (Fig. 1).

Sie werden auch in gleicher Weise in einem Zähler 26, einem Ausgabe-Register 29 mit Zeittakt 30 usw. verarbeitet, wie in Fig. 1 dargestellt.

Vom Schaltwerk 15 der Fig. 1 unterscheidet sich das Schaltwerk 46 dadurch, daß das Ausgabe-Schaltnetz 49 auch direkt an die Eingangssignale 12 bis 14 angeschlossen ist. Das Schaltwerk 46 ist dadurch als technische Realisierung eines Mealy-Automaten charakterisiert (Steinbuch, Rupprecht, a.a.O.).

Da das Ausgabe-Schaltnetz 49 nicht nur an Signale 57 angeschlossen ist, die als Ausgang des Registers 48 entstehen, sondern auch direkt an die Eingangssignale 12,13 und 14, kann das Ausgabe-Schaltnetz 49 nicht als trivial es Einheitsschaltnetz wie das Ausgabeschaltnetz 18 in Fig. 1 realisiert werden.

Aus der komplexen Struktur folgt die Möglichkeit von Funktion-Hazards, d. h. es können Störeffekte in den Ausgängen 51 bis 55 auftreten. Um daraus resultierende Fehlfunktionen der Schaltungsanordnung zu vermeiden, muß das Register 50 vorgesehen werden.

Die Schaltungsanordnung mit einem getakteten Schaltwerk 46 nach dem Modell eines Mealy-Automaten ist daher mit dem Ausgabe-Schaltnetz 49 und dem Register 50 aufwendiger aufgebaut als die in Fig. 1 gezeigte Schaltung mit dem Schaltwerk 15 nach dem Modell eines Moore-Automaten.

Der Zustandsübergangsgraph, der die Funktion des Schaltwerks 46 als Vierfach-Interpolator mit erfindungsgemäßer Fehlersignalerzeugung (23) festlegt, ergibt sich aus der bekannten Übertragung des Zustandsübergangsgraphen für den Moore-Automaten (Fig. 2) auf die Version für einen Mealy-Automaten.

Das erfindungsgemäße Verfahren kann mit getakteten Schaltwerken realisiert werden, die die digitale Elektronik verwenden. Beispielsweise kann das Schaltwerk 15 nach den Fig. 1 und 2 in einem programmierbaren Logik-Baustein PLD, z.B. Type EP320PC der Firma Altera untergebracht werden. Ein solcher Baustein enthält allgemeine Schaltnetze und Register. In einem Programmiervorgang werden Verbindungsleitungen festgelegt und so die gewünschte Schaltwerkstruktur erreicht.

Die erfindungsgemäßen Verfahren und Anordnungen können aber auch in anderen Techniken realisiert werden, so z.B. mit optischer Signalverarbeitung.

Die Anwendung der Erfindung ist am Beispiel der Präzisions-Dimensions-Meßmaschinen dargestellt worden. Sie kann jedoch allgemein bei Systemen mit Gray-Code-Signalen Anwendung finden.

Die Erfindung kann auch auf n-Bit-Gray-Code-Signale mit n größer als 2 angewendet werden.

**Ansprüche**

1. Verfahren zur Umwandlung von Gray-Code-Signalen in Zählimpulse und zur Bildung eines Zählerstandes, zur Erkennung von Gray-Code verletzenden Störsignalen und zur Bildung eines Fehlersignals, **dadurch gekennzeichnet,** daß ein endlicher Automat die Gray-Code-Signale (12,13) verarbeitet und daß dieser Automat kein Fehlersignal (23) bildet, wenn auf eine Änderung zweier Eingangssignale (12,13) innerhalb eines Zeitintervalls, also eine Gray-Code-Verletzung, die nächstfolgende Signaländerung wieder innerhalb eines Zeitintervalls zwei Eingangssignale (12,13) umfaßt, also eine zweite Gray-Code-Verletzung ist.

2. Verfahren nach Anspruch 1, **dadurch gekennzeichnet,** daß der Automat ein Moore-Automat ist.

3. Verfahrens nach Anspruch 1, **dadurch gekennzeichnet,** daß der Automat ein Mealy-Automat ist.

4. Verfahren nach mindestens einem der Ansprüche 1 bis 3, **dadurch gekennzeichnet,** daß

   a) Zwei-Zustands-Logiksignale verwendet werden,

   b) Signaländerungen geänderte Zustände des Automaten bewirken,

   c) ein Zeittakt (10,20) vorgesehen ist, der die Zeitintervalle für die Signalverarbeitung festlegt.

5. Verfahren nach mindestens einem der Ansprüche 1 bis 4, **dadurch gekennzeichnet,** daß bei der Umwandlung der Gray-Code-Signale (12,13) in die Zählimpulse (21,22) eine Einfach-, Zweifach- oder Vierfach-Interpolation ausgeführt wird.

6. Verfahren nach mindestens einem der Ansprüche 1 bis 5, **dadurch gekennzeichnet,** daß das Verfahren bei der automatischen Dimensionsmessung verwendet wird.

7. Verfahren nach mindestens einem der Ansprüche 1 bis 6, **dadurch gekennzeichnet,** daß

   a) der Automat zwei Zählimpulse (21,22) bildet, die einen Auf-/Ab-Zähler (26) steuern und

   b) die Eingangssignale (5,6,8) mit dem Automaten synchronisiert werden und

   c) Ausgangssignale (24,25) des Automaten (15) unj des Zählers (26) mit der nachfolgenden Signalverarbeitung (31,32) synchronisiert werden.

8. Verfahren nach mindestens einem der Ansprüche 5 bis 7, **dadurch gekennzeichnet,** daß zwei im Automaten für die interne Funktion der Fehlererkennung gebildete Signale (24,25) die einen 2-Bit-Gray-Code-Zähler für die Gray-Code-Signale (12,13) darstellen, als zusätzliche Ausgangssignale bereitgestellt werden und zur Synchronisation der Einfach-, Zweifach- oder Vierfach-Interpolation mit einer Feininterpolation verwendet werden.

9. Verfahren nach mindestens einem der Ansprüche 4 bis 8, **dadurch gekennzeichnet,** daß der Automat einen Zählimpuls (21,22) durch mindestens ein Zeitintervall des Zeittaktes (10,20) vom nächsten Zählimpuls (21,22) trennt.

10. Schaltungsanordnung zur Umwandlung von Gray-Code-Signalen in Zählimpulse und zur Bildung eines Zählerstandes, welche Gray-Code verletzende Störimpulse erkennt und einen entsprechenden Signalpegel an einem Fehlerausgang bildet, **dadurch gekennzeichnet,** daß ein getaktetes Schaltwerk (15) mit Eingängen (12,13) für Gray-Code-Signale und mit einem Fehlerausgang (23) enthalten ist, und daß dieses Schaltwerk (15) am Fehlerausgang (23) kein Fehlersignal aktiviert, wenn nach einer Änderung zweier Signalpegel an den Eingängen (12,13) für Gray-Code-Signale innerhalb eines Zeitintervalls eines Zeittaktes (10,20) die nächstfolgende Signaländerung wieder innerhalb eines Zeitintervalls des Zeittaktes (10,20) an zwei Eingängen (12,13) für Gray-codierte Signale erfolgt.

11. Schaltungsanordnung nach Anspruch 10, **dadurch gekennzeichnet,** daß

a) das getaktete Schaltwerk (15) nach dem Modell eines Moore-Automaten aufgebaut ist und

b) aus einem Überführungs-Schaltnetz (16), einem Register (17) und einem Ausgabe-Schaltnetz (18) zusammengesetzt ist und

c) das Ausgabe-Schaltnetz (18) als triviales Einheitsnetz realisiert ist und

d) den Eingängen (12,13,14) des Schaltwerks (15) ein Register (11) vorgeschaltet ist und

e) zwei Ausgängen (21,22) des Schaltwerks ein Auf-/Ab-Zähler (26) nachgeschaltet ist und

f) die Ausgänge des Zählers (26) und weitere Ausgänge (24,25) des Schaltwerks (15) einem weiteren Register (29) zugeführt sind.

12. Schaltungsanordnung nach Anspruch 10, **dadurch gekennzeichnet,** daß

a) das getaktete Schaltwerk (46) nach dem Modell eines Mealy-Automaten aufgebaut ist, und

b) aus einem Überführungs-Schaltnetz (47), einem Register (48) und einem Ausgabe-Schaltnetz (49) zusammengesetzt ist und

c) den Eingängen (12,13,14) des Schaltwerks (46) ein Register (11) vorgeschaltet ist und

d) den Ausgängen (51-55) des Schaltwerks (46) ein Register (50) nachgeschaltet ist und

e) zwei Ausgänge (51,52) des Schaltwerks (46) über das nachgeschaltete Register (50) an einen Auf-/Ab-Zähler (26) gelegt sind und

f) die Ausgänge des Zählers (26) und weitere Ausgänge (24, 25) des nachgeschalteten Registers (50) einem weiteren Register (29) zugeführt sind.

13 Schaltunganordnung nach mindestens einem der Ansprüche 10 bis 12, **dadurch gekennzeichnet,** daß

a) die Schaltungsanordnung in einer Präzisions-Dimensionsmeßmaschine eingesetzt wird und

b) die Gray-codierten Signale (12,13) als 90° phasenverschobene Rechteck-Logiksignale durch eine Signalformeinrichtung (4) aus Sinus- und Cosinus-Signalen gewonnen werden und

c) die Sinus- und Cosinus-Signale (2,3) aus einer Maßstabsabtastung (1) gewonnen werden und

d) die Schaltungsanordnung als Einfach-, Zweifach- oder Vierfach-Interpolator geschaltet ist, der für jede vierte, zweite oder erste Signalflanke der Gray-codierten Signale (12,13) einen Zählimpuls (21,22) abgibt.

14. Schaltungsanordnung nach mindestens einem der Ansprüche 10 bis 13, **dadurch gekennzeichnet,** daß

a) das Überführungs-Schaltnetz (16,47) unter anderem auch zwei Signalausgänge für die Funktion der Fehlererkennung und -meldung aufweist, die einen 2-Bit-Gray-Code-Zähler für die Gray-codierten Signale (12,13) darstellen und daß

b) diese zwei Signalausgänge über das Register (17,48) und das Ausgabe-Schaltnetz (18,49) als Ausgangssignale (24,25) des getakteten Schaltwerks (15,46) über das weitere Register (29,50) zu zwei weiteren Ausgängen der Schaltungsanordnung geführt werden und

c) die zwei weiteren Ausgänge einer Anordnung (31) zur Synchronisation mit einer Feininterpolationseinrichtung (27) zugeführt sind.

15. Schaltungsanordnung nach mindetens einem der Ansprüche 10 bis 14, **dadurch gekennzeichnet,** daß das getaktete Schaltwerk (15,46) so aufgebaut ist, daß ein Zählimpuls (21,22) durch mindestens ein Zeitintervall des Zeittaktes (20) vom nächsten Zählimpuls (21,22) getrennt ist.

Fig.1

EP 0 328 093 A2

# Fig.2a

# Fig.2b

Fig.3

EP 0 328 093 A2

Fig. 4

Fig. 5